# EUROPÄISCHE PATENTANMELDUNG

(11) **EP 1 280 195 A2**
(43) Veröffentlichungstag der Anmeldung: **29.01.2003**
(21) Anmeldenummer: 02015979.4
(22) Anmeldetag: 18.07.2002
(51) Int. Cl.: H01L 21/336, H01L 29/788, H01L 21/8247, H01L 27/115

(54) **Verfahren zur Herstellung eines nichtflüchtigen Halbleiterspeichers sowie nichtflüchtiger Halbleiterspeicher**

(30) Priorität: 27.07.2001 DE 10136582
(71) Anmelder: Micronas GmbH, 79108 Freiburg (DE)
(72) Erfinder: Frerichs, Heinz-Peter, 79271 St. Peter (DE)
(74) Vertreter: Patentanwälte Westphal, Mussgnug & Partner

(57) **Zusammenfassung**

Um ein EEPROM in eine integrierte Schaltung einbetten zu können, wird in ein p-Substrat (20) eine n-Wanne (21) implantiert, in die eine für hohe Spannungen ausgelegte pHV-Schicht (22) implantiert wird. Neben der n-Wanne (21) wird ein Injektor (23) implantiert. Zur elektrischen Isolation sind die n-Wanne (21), die p-Wanne (22), der Injektor (23) und das p-Substrat (20) abwechselnd mit Dünnund Dickoxiden (30, 31, 32, 24, 25, 26, 27) bedeckt. Auf die Dünn- und Dickoxide ist eine Floating-Gate-Schicht (28) aufgetragen, um in den n-Wannen (21) Floating-Gate-Kapazitäten (PC) zu bilden, damit an die p-Wanne (22) sowohl positive als auch negative Spannungen anlegbar sind.

## Beschreibung

Die Erfindung betrifft ein Verfahren zur Herstellung eines nichtflüchtigen Halbleiterspeichers gemäß dem Oberbegriff des Anspruchs 1.

Die Erfindung betrifft weiter einen nichtflüchtigen Halbleiterspeicher gemäß dem Oberbegriff des Anspruchs 2.

In zunehmendem Maße wird von integrierten Schaltungen (ICs) mit Halbleiterspeichern gefordert, dass bestimmte Daten nichtflüchtig abgespeichert werden können und somit auch ohne Versorgungsspannung erhalten bleiben. Zur nichtflüchtigen Speicherung von Daten sind EEPROM-(Electrically Erasable Programmable Read-Only Memory) Speicher bekannt, die elektrisch beschrieben und wieder gelöscht werden können. Zum Schreiben und Löschen der einzelnen Speicherzellen sind im allgemeinen Spannungen von mindestens 12 Volt auf Zellen-Ebene und somit etwa Spannungen von 15 Volt für die Pass-Gates erforderlich.

Bei der Integration dieser Speicher mit integrierten Standard-Schaltungen (embedded EEPROM) ergibt sich jedoch das Problem, dass die integrierten Schaltungen und die Prozesse zu ihrer Herstellung im allgemeinen für 5 Volt oder weniger ausgelegt sind. Um die zur Einbettung der EEPROM-Speicher in eine integrierte Schaltung notwendigen hohen Spannungen mit einem Standard IC-Prozeß handhaben zu können, sind in der Regel zahlreiche zusätzliche Prozeßschritte, d.h. etwa fünf bis acht Maskenschritte erforderlich. Dies erhöht die Herstellungskosten für die integrierte Schaltung erheblich.

Der Erfindung liegt deshalb die Aufgabe zugrunde, ein Verfahren zur Herstellung eines nichtflüchtigen Halbleiterspeichers sowie einen nichtflüchtigen Halbleiterspeicher zu schaffen, der mit wesentlich geringerem Aufwand und somit kostengünstiger in eine integrierte Standardschaltung eingebettet werden kann.

Verfahrensmäßig wird diese Aufgabe mit den im Anspruch 1 angegebenen Merkmalen gelöst.

Vorrichtungsmäßig wird diese Aufgabe mit den im Anspruch 2 angegebenen Merkmalen gelöst.

Das erfindungsgemäße Verfahren sieht vor, in ein p-Substrat eine n-Wanne zu implantieren, in welche eine für hohe Spannungen als sog. pHV-Schicht ausgebildete p-Wanne implantiert wird. Neben der n-Wanne wird in vorgebbarem Abstand eine als Injektor ausgebildete n+-Wanne implantiert. Die n-Wanne und ein erster Teil des zwischen der n-Wanne und dem Injektor liegenden p-Substrats werden mit einer Dickoxid-Schicht bedeckt. Die p-Wanne, der Injektor und ein zweiter Teil des zwischen der n-Wanne und dem Injektor liegenden p-Substrats werden dagegen mit einer Dünnoxid-Schicht bedeckt. Auf die Dick- und Dünnoxid-Schicht wird eine Floating-Gate-Schicht aufgetragen.

Durch den erfindungsgemäßen Schichtaufbau werden in den n-Wannen Floating-Gate-Kapazitäten erzeugt, so daß an die p-Wanne sowohl positive als auch negative Spannungen anlegbar sind. Die zum Programmieren, Löschen und Schreiben der Speicherzellen erforderlichen Spannungen in Höhe von mindestens 12V werden durch Anlegen einer Spannung von -7V und +5V erzeugt.

Die Unteransprüche haben vorteilhafte Weiterbildungen der Erfindung zum Inhalt.

Weitere Einzelheiten, Merkmale und Vorteile der Erfindung ergeben sich aus der folgenden Beschreibung einer bevorzugten Ausführungsform anhand der Zeichnung. Es zeigt:
- Fig. 1: eine Schichtstruktur eines P-Kanal-Transistors für höhere Spannungen gemäß dem Stand der Technik;
- Fig. 2: eine Schichtstruktur einer erfindungsgemäßen EEPROM-Speicherzelle;
- Fig. 3: eine Draufsicht auf die in Figur 2 gezeigte Struktur; und
- Fig. 4: ein elektrisches Schaltbild der in Figur 3 gezeigten EEPROM-Speicherzelle;

Die Erfindung sieht vor, zum Schreiben und Löschen der EEPROM-Speicherzellen p-Kanal Transistoren zu verwenden, die durch eine zusätzliche Implantation im Drainbereich geeignet sind, die zum Schreiben und Löschen erforderlichen hohen negativen Spannungen zu erzeugen bzw. zu schalten. Zur Implantation dient vorzugsweise Bor.

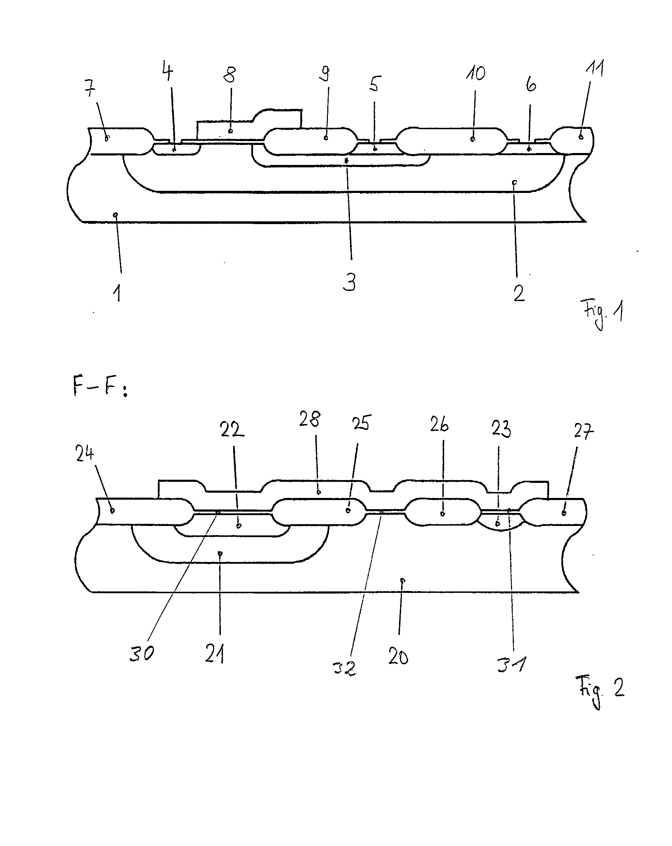

Figur 1 zeigt eine Schichtstruktur eines p-Kanal-Transistors für höhere Spannungen - Spannungen höher als 5V - gemäß dem Stand der Technik.

Die Struktur umfaßt ein p-Substrat 1, in dem eine n-Wanne 2 ausgebildet ist und über einen n+-Wannenanschluß 6 kontaktiert wird. In die n-Wanne 2 sind ein erster p+-Bereich 4, der eine Source-Elektrode 4 bildet, und ein zweiter p+-Bereich 3 eingebettet, der auch P-High-Voltage-Bereich genannt wird und eine Drain-Elektrode 3 bildet. Dieser p-High-Voltage-Bereich wird über eine p+-Diffusion 5 kontaktiert. Auf die Oberseite sind Dickoxide 7, 9, 10 und 11 aufgebracht, um die unterschiedlich dotierten Gebiete gegeneinander zu isolieren. Zwischen dem Drain-Bereich 3 und dem Source-Bereich 4 ist über einem Dünnoxid eine Gate-Elektrode 8 angeordnet, die eine Überlappung auf das Dickoxid 9 aufweist.

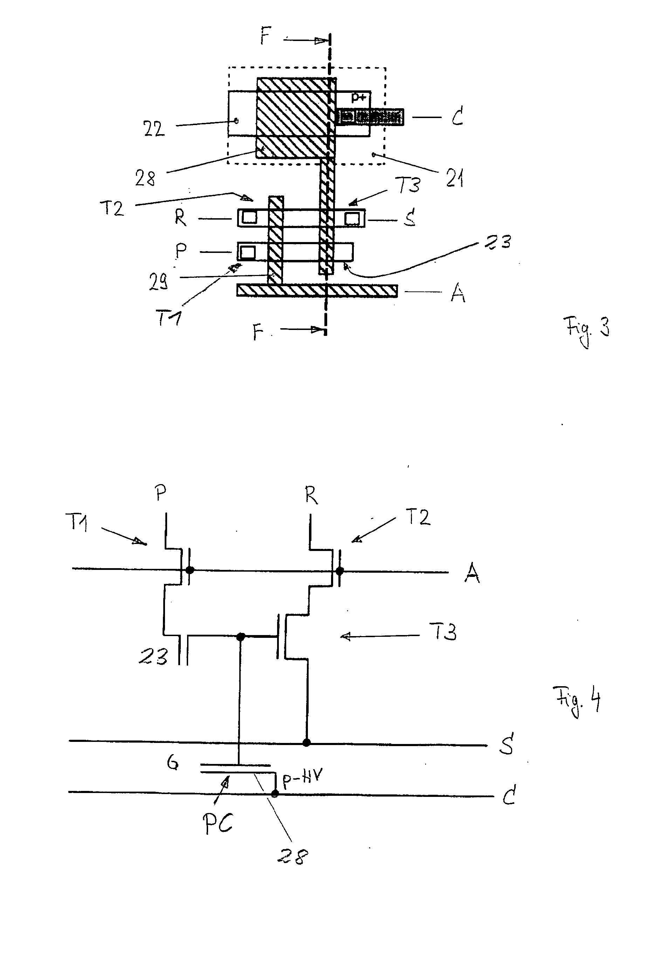

In der Figur 2 ist ein Ausführungsbeispiel einer erfindungsgemäßen EEPROM-Zelle dargestellt.

In ein p-Substrat 20 ist eine n-Wanne 21 implantiert, in welche ein p-High-Voltage-Bereich 22 eingebettet ist. In vorgegebenem Abstand ist neben der n-Wanne 21 ein n+-Bereich 23 als Injektor implantiert. Der p-High-Voltage-Bereich 22 - abgekürzt pHV-Bereich - ist mit einem Dünnoxid 30 bedeckt. Der Injektor 23 ist mit einem Dünnoxid 31 bedeckt. Auf einen ersten Teil des zwischen der n-Wanne 21 und dem Injektor 23 liegenden p-Substrats ist ebenfalls ein Dünnoxid 32 aufgebracht. Die n-Wanne 21 ist mit Dickoxiden 24 und 25 bedeckt. Ein zweiter Teil des neben der n-Wanne 21 und dem Injektor 23 liegenden p-Substrats 20 ist mit einem Dickoxid 26 bedeckt. Der neben dem Injektor 23 liegende Bereich des p-Substrats 20 ist mit einem Dickoxid 27 bedeckt. Der pHV-Bereich 22, das Dickoxid 25, das Dünnoxid 32, das Dickoxid 26 sowie der Injektor 23 sind vollständig mit einer Floating-Gate-Schicht 28 bedeckt, während die Dickoxide 24 und 27 nur teilweise mit der Floating-Gate-Schicht bedeckt sind.

Zwischen den Dickoxiden 25 und 26 liegt der Kanal eines Lesetransistors T3. Der Injektor 23 bildet den Injektor der EEPROM-Speicherzelle. Die Dickoxide 24, 25, 26 und 27 dienen zur Isolation der unterschiedlich dotierten Gebiete.

Durch die erfindungsgemäße Implantation des pHV-Bereiches 22 in die n-Wanne 21 werden in den n-Wannen einer erfindungsgemäßen EEPROM-Speicherzelle Floating-Gate-Poly-Kapazitäten erzeugt, die aus dem pHV-Bereich 22, der Floating-Gate-Schicht 28 und dem Dünnoxid 30 bestehen. Dadurch ergibt sich der Vorteil, daß sich an die pHV-Schicht 22 sowohl positive als auch negative Spannungen anlegen lassen, die die Floating-Gate-Schicht 28 auf ein positives oder negatives Potential ziehen und damit das Löschen und Schreiben von Daten in den EEPROM-Speicherzellen ermöglichen.

In der Figur 3 ist eine Draufsicht der in Figur 2 gezeigten Struktur abgebildet.

In dieser Draufsicht ist die n-Wanne 21 mit dem eingebetteten pHV-Bereich 22, der p+-dotiert ist, zu sehen. An den pHV-Bereich 22 ist eine Steuerleitung C zum Löschen und Schreiben der Daten der EEPROM-Speicherzelle angeschlossen. Außer der Floating-Gate-Poly-Schicht 28 ist eine weitere Floating-Gate-Poly-Schicht 29 vorgesehen, die eine Zugriffsleitung A darstellt und mit den Steueranschlüssen des Schreibtransistors T1 und des Lesetransistors T2 verbunden ist. An den Schreibtransistor T1 ist eine Schreibleitung P und an den Lesetransistor T2 eine Leseleitung R angeschlossen. Der Transistor T3, an den eine Source-Leitung S angeschlossen ist, dient ebenfalls als Lesetransistor. Wo die Schreibleitung P und die Floating-Gate-Poly-Schicht 28 übereinander liegen, ist unter der Schreibleitung P der Injektor 23 angeordnet.

In Figur 4 ist das elektrische Schaltbild des in den Figuren 2 und 3 gezeigten erfindungsgemäßen Ausführungsbeispieles gezeigt.

An den ersten Kanalanschluß des Schreibtransistors T1 ist die Schreibleitung P1 angeschlossen. An den ersten Kanalanschluß des Lesetransistors T2 ist die Leseleitung R angeschlossen. Der Steueranschluß des Schreibtransistors T1 und des Lesetransistors T2 ist mit der Zugriffsleitung A verbunden. Der andere Kanalanschluß des Lesetransistors T2 ist über die Kanalstrecke des Lesetransistors T3 mit einer Source-Leitung S verbunden. Der andere Kanalanschluß des Schreibtransistors T1 ist über den Injektor 23 mit dem Steueranschluß des Lesetransistors T3 verbunden, der mit der Floating-Gate-Schicht 28 verbunden ist, die zusammen mit der pHV-Schicht 22 die Poly-Kapazität P bildet. Mit der pHV-Schicht 22 ist die Steuerleitung C zum Löschen und Schreiben von Daten verbunden.

Zum Lesen, Löschen und Schreiben der erfindungsgemäßen EEPROM-Speicherzelle sind folgende Spannungen erforderlich:

| | Lesen | Löschen | Schreiben |
|---|---|---|---|
| Schreibleitung P | | | |
| ausgewählt | 0 V | 0 V | ca. 5 V |
| Schreibleitung P | | | |
| nicht ausgewählt | 0 V | 5 V | 0 Volt |
| Steuerleitung C | 0-1 V | ca. 12 V | ca. -7 V |
| Zugriffsleitung A | V_{dd} | ca. 5 V | ca. 5 V |
| Leseleitung R | 1 V | Floating | Floating |
| Sourceleitung S | 0 V | Floating | Floating |

Das erfindungsgemäße Verfahren zeichnet sich durch den Vorteil aus, daß zur Herstellung des erfindungsgemäßen nichtflüchtigen Halbleiterspeichers bei einem Standard-C-MOS-Prozeß nur zwei zusätzliche Masken benötigt werden.

### Bezugszeichenliste

- 1: p-Substrat
- 2: n-Wanne
- 3: pHV-Bereich
- 4: p+-Bereich
- 5: p+Drain
- 6: n+Bereich
- 7: Dickoxid
- 8: Gate
- 9: Dickoxid
- 10: Dickoxid
- 11: Dickoxid
- 20: p-Substrat
- 21: n-Wanne
- 22: pHV-Bereich
- 23: n+-Bereich, Injektor
- 24: Dickoxid
- 25: Dickoxid
- 26: Dickoxid
- 27: Dickoxid
- 28: Floating-Gate-Schicht
- 29: Floating-Gate-Schicht
- 30: Dünnoxid
- 31: Dünnoxid
- 32: Dünnoxid

- A: Zugriffsleitung
- C: Steuerleitung
- G: Gate
- P: Schreibleitung
- PC: Poly-Kapazität
- R: Leseleitung
- S: Source-Leitung
- T1: Schreibtransistor
- T2: Lesetransistor
- T3: Lesetransistor

## Patentansprüche

1. Verfahren zur Herstellung eines mit einem Schreib- und mindestens einem Lesetransistor (T1, T2, T3) ausgestatteten nichtflüchtigen Halbleiterspeichers, der in eine integrierte Schaltung eingebettet wird, deren Betriebsspannung geringer ist als die Spannungen zum Schreiben, Lesen und Löschen der im nichtflüchtigen Halbleiterspeicher gespeicherten Daten,
**gekennzeichnet durch** folgende Verfahrensschritte:
in ein p-Substrat (20) wird eine n-Wanne (21) implantiert,
in die n-Wanne (21) wird eine für hohe Spannungen ausgelegte und als pHV-Schicht ausgebildete p-Wanne (22) implantiert,
neben der n-Wanne (21) wird in vorgebbarem Abstand eine als Injektor ausgebildete n+-Wanne (23) implantiert,
die n-Wanne (21) und ein vorgebbarer erster Teil des zwischen der n-Wanne (21) und dem Injektor (23) liegenden p-Substrats (20) werden mit einer Dickoxid-Schicht (26) bedeckt,
die p-Wanne (22), der Injektor (23) und ein vorgebbarer zweiter Teil des zwischen der n-Wanne (21) und dem Injektor (23) liegenden p-Substrats (20) werden mit einer Dünnoxid-Schicht (32) bedeckt,
auf die Dick- und Dünnoxide (24, 25, 26, 27, 30, 31, 32) wird eine Floating-Gate-Schicht (28) aufgetragen,
wobei für die Transistoren (T1, T2, T3) p-Kanaltransistoren vorgesehen werden und wobei in den n-Wannen (21) Floating-Gate-Kapazitäten (PC) gebildet werden, so daß an die p-Wanne (22) sowohl positive als auch negative Spannungen anlegbar sind.

2. Mit einem Schreib- und mindestens einem Lesetransistor (T1, T2, T3) ausgestatteter nichtflüchtiger Halbleiterspeicher, der in eine integrierte Schaltung eingebettet ist, deren Betriebsspannung geringer ist als die Spannungen zum Schreiben, Lesen und Löschen der im nichtflüchtigen Halbleiterspeicher gespeicherten Daten,
**gekennzeichnet durch** folgenden Schichtaufbau:
in ein p-Substrat (20) ist eine n-Wanne (21) implantiert,
in die n-Wanne (21) ist eine für hohe Spannungen ausgelegte und als pHV-Schicht ausgebildete p-Wanne (22) implantiert,
neben der n-Wanne (21) ist in vorgebbarem Abstand eine als Injektor ausgebildete n+-Wanne (23) implantiert,
die n-Wanne (21) und ein vorgebbarer erster Teil des zwischen der n-Wanne (21) und dem Injektor (23) liegenden p-Substrats (20) sind mit einer Dickoxid-Schicht (26) bedeckt,
die p-Wanne (22), der Injektor (23) und ein vorgebbarer zweiter Teil des zwischen der n-Wanne (21) und dem Injektor (23) liegenden p-Substrats (20) sind mit einer Dünnoxid-Schicht (32) bedeckt,
auf die Dick- und Dünnoxide (24, 25, 26, 27, 30, 31, 32) ist eine Floating-Gate-Schicht (28) aufgetragen,
wobei für die Transistoren (T1, T2, T3) p-Kanaltransistoren vorgesehen sind und wobei in den n-Wannen (21) Floating-Gate-Kapazitäten (PC) gebildet sind, so daß an die p-Wanne (22) sowohl positive als auch negative Spannungen anlegbar sind.

3. Verfahren nach Anspruch 1 oder nichtflüchtiger Halbleiterspeicher nach Anspruch 2,
**dadurch gekennzeichnet,daß** für den Injektor (23) Bor vorgesehen wird bzw. ist.

4. Verfahren oder nichtflüchtiger Halbleiterspeicher nach einem der vorangehenden Ansprüche,
**dadurch gekennzeichnet,daß** an die Steuerelektroden des Schreibtransistors (T1) und des einen Lesetransistors (T2) eine Zugriffsleitung (A) angeschlossen wird bzw. ist, daß an den ersten Kanalanschluß des Schreibtransistors (T1) eine Schreibleitung (P) angeschlossen wird bzw. ist, daß an den ersten Kanalanschluß des einen Lesetransistors (T2) eine Leseleitung (R) angeschlossen wird bzw. ist, daß der zweite Kanalanschluß des Schreibtransistors (T1) über den Injektor (23) mit der Steuerelektrode des anderen Lesetransistors (T3) und mit der Poly-Kapazität (PC) verbunden wird bzw. ist, an deren einen Elektrode eine Steuerleitung (C) angeschlossen wird bzw. ist, und daß der zweite Kanalanschluß des einen Lesetransistors (T2) mit dem ersten Kanalanschluß des anderen Lesetransistors (T3) verbunden wird bzw. ist, an dessen zweiten Kanalanschluß eine Source-Leitung (S) angeschlossen wird bzw. ist.

5. Verfahren oder nichtflüchtiger Halbleiterspeicher nach einem der vorangehenden Ansprüche,
**dadurch gekennzeichnet,daß** eine weitere Floating-Gate-Schicht (29) auf die Schreibleitung (P) und die Leseleitung (R) aufgebracht wird bzw. ist und an die Zugriffsleitung (A) angeschlossen wird bzw. ist.

6. Verfahren oder nichtflüchtiger Halbleiterspeicher nach einem der vorangehenden Ansprüche,
**dadurch gekennzeichnet,daß** der nichtflüchtige Halbleiterspeicher als EEPROMausgebildet wird bzw. ist.
